# EUROPEAN PATENT SPECIFICATION

(11) **EP 0 619 649 B1**
(45) Date of publication and mention of the grant of the patent: **29.07.1998**
(21) Application number: 94105392.8
(22) Date of filing: 07.04.1994
(51) Int. Cl.: H03H 17/02

(54) **Digital filter**
Digitales Filter
Filtre numérique

(30) Priority: 09.04.1993 JP 105976/93
(43) Date of publication of application: 12.10.1994
(73) Proprietor: KABUSHIKI KAISHA KENWOOD, Shibuya-ku Tokyo (JP)
(72) Inventor: Iwata, Toshio, Sagamihara-shi, Kanagawa-ken (JP)
(74) Representative: Patentanwälte Leinweber & Zimmermann

(56) References cited:
- US-A- 5 136 267
- COMPUTERS IN CARDIOLOGY; SEPTEMBER 23-26 1991 VENICE (IT); IEEE COMPUTER SOCIETY PRESS IEEE PUBLICATION, NEW YORK (US), pages 145 - 148 L. SöRNMO 'Time-varying filtering for removal of baseline wander in exercise ECGs.'

## Description

### BACKGROUND OF THE INVENTION

### Field of the Invention

The present invention relates to a digital filter, and more particularly to a digital filter in which an output of the digital filter is selected from outputs of a plurality of digital low-pass filters (hereinafter simply called a low-pass filter) in accordance with a correlation output detected from input data.

### Related Background Art

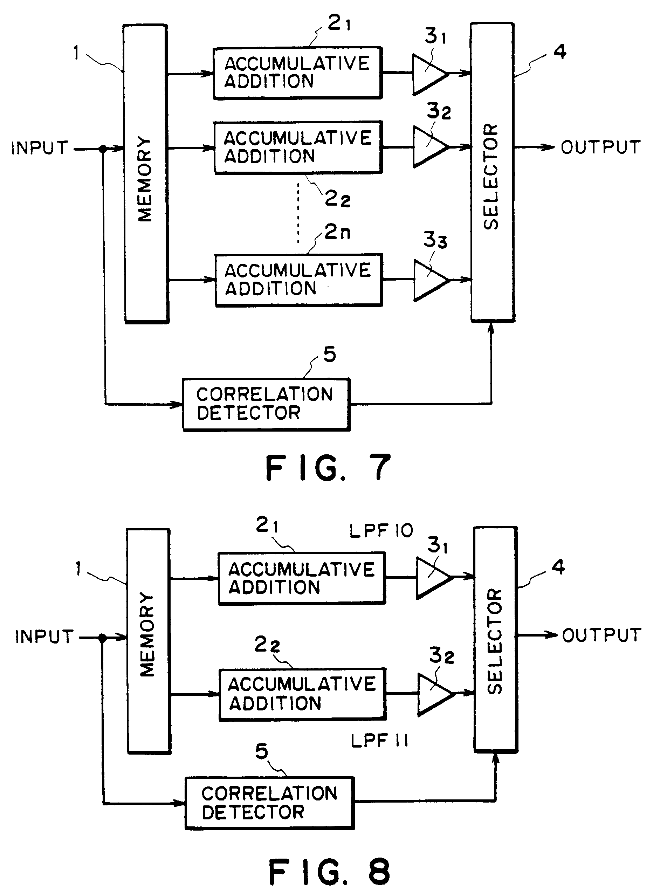

In a conventional digital filter such as shown in Fig.7, an output of the digital filter is selected from outputs of K low-pass filters disposed in parallel each having a different number Ni of taps, in accordance with a correlation output detected from input data. Specifically, input data is sampled by a pulse having a frequency of fₛ and written in a memory in response to a write clock pulse (hereinafter simply called a clock) synchronizing with the frequency fₛ. Ni data delayed by z + 1, z + 2,... clocks (z is a natural number including 0) are read from the memory 1 and added by accumulative adders 2i whose outputs are divided by respective tap numbers Ni by multipliers 3i and supplied to a selector 4. The selector 4 selectes the outputs of the multipliers 3i in accordance with a correlation of input data detected by a correlation detector 5.

With the conventional digital filter, it is necessary to read data corresponding in number to at least the maximum tap number from the memory 1 in a time period of 1/fₛ and to add Ni data at the accumulative adders 2i. An output of the digital filter sequentially selected by the selector 4 has distortions because each low-pass filter has a different group delay time.

The operation of such a conventional digital filter will be described in more detail with reference to Fig.8. This digital filter has two low-pass filters. The clock frequency is 352.8 (= 8 * 44.1) kHz, the number Ni of taps of a low-pass filter LPF10 is 15, the number Ni of taps of a low-pass filter LPF11 is 31, and z is 0.

In this example, a memory 1, an accumulative adder 2₁, and a multiplier 3₁ constitute the low-pass filter LPF10 having the tap number Ni = 15, and the memory 1, an accumulative adder 2₂, and a multiplier 3₂ constitute the low-pass filter LPF11 having the tap number Ni = 31. Input data is sequentially written in a memory 1 in response to a clock having the frequency fₛ = 352.8 kHz. In parallel with this data write, the accumulative adders 2₁ and 2₂ are reset and thereafter, 31 sets of data delayed by 0, 1, 2,..., 30 clocks from the input data are read from the memory 1 in a time period of 1/325.8 kHz = 2.83 µs. 15 sets of data delayed by 0, 1, 2,..., 14 clocks are inputted to the accumulative adder 2₁, and additions are performed 15 times. The accumulative output is multiplied by 1/15 by the multiplier 3₁ and outputted to a selector 4. 31 sets of data delayed by 0, 1, 2,..., 30 clocks from the input data are inputted to the accumulative adder 2₂, and additions are performed 31 times. The accumulative output is multiplied by 1/31 by the multiplier 3₂ and outputted to the selector 4.

It is necessary to read 31 sets of data in a time period of 1/325.8 kHz = 2.83 µs and repeat additions 31 times totaling in 46 times (15 + 31 times). Either the output of the low-pass filter LPF10 or the output of the low-pass filter LPF11 is selected in accordance with a correlation output of a correlation detector 5. A group delay time required for the calculation by an FIR digital filter is (Ni - 1)/2 clocks where Ni is the number of taps. Therefore, the group delay time of the low-pass filter LPF10 is 7 clocks, and the group delay time of the low-pass filter LPF11 is 15 clocks.

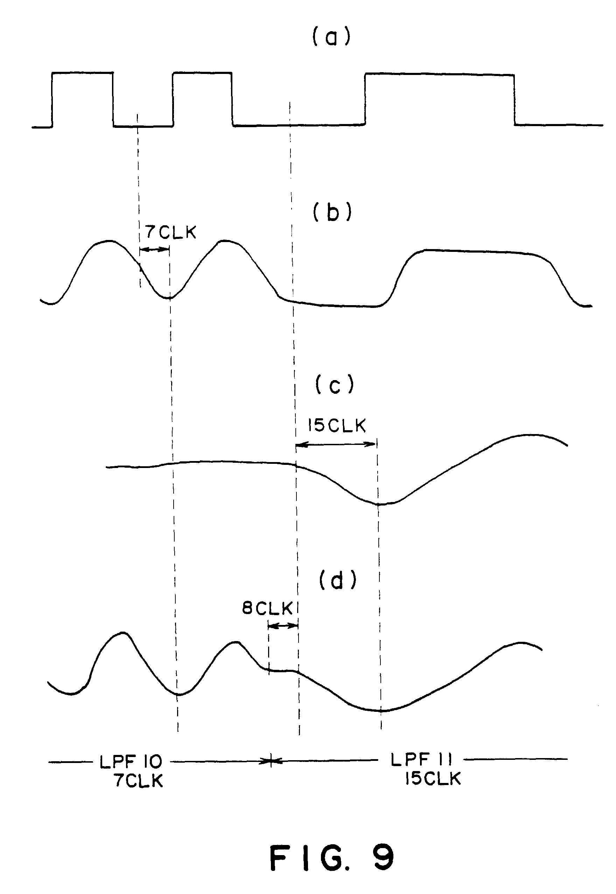

For input data schematically shown in Fig.9 at (a), an output waveform of the low-pass filter LPF10 is shown in Fig.9 at (b), and an output waveform of the low-pass filter LPF11 is shown in Fig.9 at (c). The correlation detector 5 detects a correlation between input data at one time point and the following input data. For the input data shown in Fig.9 at (a), the first half input data has a low correlation so that an output of the low-pass filter LPF10 is selected, whereas the second half input data has a high correlation so that an output of the low-pass filter LPF11 is selected. Therefore, in this example, an output shown in Fig.9 at (d) is obtained. A distortion is generated because the first half input data having high frequency components and the second half input data having low frequency components have a difference of 8 (15 - 7) clocks in group delay time.

As described above, it is necessary for a conventional digital filter to read data corresponding in number to the maximum tap number in a time period of 1/fₛ and repeat a number of additions as many as the tap number Ni. Furthermore, an output of the digital filter has a distortion generated by an operation of the selector because of a different group delay time of each low-pass filter.

"Computers in Cardiology", September 23 - 26, 1991, pages 145 - 148, discloses a time-varying filtering system. Said filtering system includes a plurality of low-pass filters each having a variable cut-off frequency, said cut-off frequency of the various filters slightly differing from one another. The cut-off frequencies are adapted to the current "level" of base line wander in an input signal.

It is an object of the present invention to provide a digital filter capable of reducing the number of data read times and reducing output distortions.

According to the invention, the above object is achieved by a digital filter as laid down in claim 1.

The digital filter may have a second selector for selecting either the output selected by the first selector or third data delayed by m clocks from the input data and read from the memory, and a second correlation detector for detecting a correlation between the output data selected by the first selector and the third data delayed by m clocks and for resetting the counter to restart counting and making the second selector to select the third data if the correlation detected by the second correlation detector does not reach a predetermined value.

In the digital filter of this invention, low-pass filters each having a different number of taps are provided. The low-pass filters read from the memory the first data delayed by [natural number m - (tap number Ni - 1)/2] clocks from the input data and the second data delayed by [natural number m + (tap number Ni - 1)/2 + 1] clocks from the input data. Each low-pass filter has the first and second multipliers and the accumulative adder. Accordingly, an output of each low-pass filter has the same group delay time so that a distortion to be caused by a difference of the group delay time between outputs selected by the selector can be suppressed. Furthermore, the number of accumulations by the accumulative adder is only the number of low-pass filters multiplied by 2 during each clock period.

In the digital filter of this invention, if noises are present in the accumulative adder, the correlation output of the second correlation detector does not reach the predetermined value so that the second selector selects the third data and the counter is reset to restart counting and the accumulative adder is reset to start accumulative addition. Accordingly, an influence of noises can be suppressed.

### BRIEF DESCRIPTION OF THE DRAWINGS

Fig.1 is a block diagram showing the structure of a digital filter according to an embodiment of the present invention.

Fig.2 shows waveforms explaining the operation of the digital filter shown in Fig.1.

Fig.3 is a block diagram showing the structure of a first modification of the embodiment.

Fig.4 shows waveforms explaining the operation of the first modification.

Fig.5 is a block diagram showing the structure of a second modification of the embodiment.

Fig.6 shows waveforms explaining the operation of the second modification.

Fig.7 is a block diagram showing the structure of a conventional digital filter.

Fig.8 is a block diagram showing the structure of another digital filter.

Fig.9 shows waveforms explaining the operation of the digital filter shown in Fig.8.

### DETAILED DESCRIPTION OF THE PREFERRED EMBODIMENTS

Embodiments of the present invention will be described.

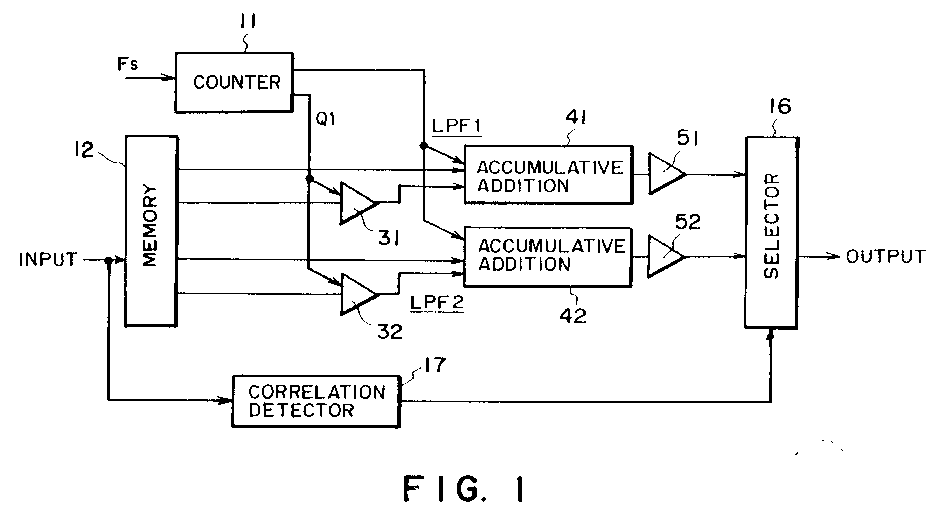

Fig.1 is a block diagram showing the structure of a digital filter according to an embodiment of the present invention. The digital filter of this embodiment has two low-pass filters (k = 2). The number Ni of taps of a low-pass filter LPF1 is 15, and the number Ni of taps of a low-pass filter LPF2 is 31. The number m is 15.

The digital filter of this embodiment has a counter 11 for counting a clock having a frequency fₛ. The counter 11 outputs a reset signal when the operation of the filter starts, and outputs a control signal Qi of "0" during a time period of Ni/fₛ and a control signal Qi of "- 1" after the time period of NI/fₛ. Input data sampled at the frequency fₛ is sequentially written in a memory 12 in response to the clock. First data delayed by [m - (Ni - 1)/2] clocks from the input data and second data delayed by [m + (Ni - 1)/2 + 1] clocks from the input data, are read from the memory 12.

The first low-pass filter LPF1 with the tap number Ni = 15 reads from the memory 12 the first data delayed by "8" clocks = [m - (Ni - 1)/2 = 15 - 14/2] clocks from the input data and the second data delayed by "23" clocks = [m + (Ni - 1)/2 + 1 = 15 + 14/2 + 1] clocks from the input data. The second low-pass filter LPF2 with the tap number Ni = 31 reads from the memory 12 the third data delayed by "0" clock = [m - (Ni - 1)/2 = 15 - 30/2 = 0 clock from the input data and the fourth data delayed by "31" clocks = [m + (Ni - 1)/2 + 1 = 15 + 30/2 + 1] clocks from the input data.

The second data is supplied to a multiplier 31 and multiplied by the control signal Qi outputted from the counter 1. The first data and output data of the multiplier 31 are supplied to an accumulative adder 41 and accumulatively added, the accumulative adder 41 being reset by the reset signal outputted from the counter 11. The accumulative output of the accumulative adder 41 is multiplied by 1/15 by another multiplier 51. The multiplier 31, accumulative adder 41, and multiplier 51 together with the counter 12 and memory 12 constitute the low-pass filter LPF1 with the tap number of 15.

The fourth data is supplied to a multiplier 32 and multiplied by the control signal Qi outputted from the counter 1. The third data and output data of the multiplier 32 are supplied to an accumulative adder 42 and accumulatively added, the accumulative adder 42 being reset by the reset signal outputted from the counter 11. The accumulative output of the accumulative adder 42 is multiplied by 1/31 by another multiplier 52. The multiplier 32, accumulative adder 42, and multiplier 52 together with the counter 11 and memory 12 constitute the low-pass filter LPF2 with the tap number of 31.

Input data is supplied to a correlation detector 17 which detects a correlation between input data at one time point and input data after the one time point. The detected correlation is supplied to a selector 16 which selects either the output of the multiplier 51 or the output of the multiplier 52 in accordance with the correlation value detected by the correlation detector 17. The selector 16 selects the output of the first low-pass filter LPF1 when the correlation value becomes smaller than a predetermined value, and selects the output of the second low-pass filter LPF2 when the correlation value takes the predetermined value or higher.

The operation of the digital filter of this embodiment constructed as above will be described assuming that the sampling frequency and clock frequency are fs = 352.8 (= 8 * 44.1) kHz.

Input data is sequentially written in the memory 12 in response to the write clock having the frequency of 352.8 kHz. At the same time when input data is written, the counter 11 outputs the reset signal to reset the accumulative adders 41 and 42. After this resetting and in parallel to writing input data into the memory 12, two sets of data delayed by "8" clocks and by "23" clocks from the input data are read from the memory 12 in a time period of 2.83 µs (= 1/352.8 kHz). The data delayed by "8" clocks is supplied to the accumulative adder 41 and accumulatively added.

The data delayed by "23" clocks is supplied to the multiplier 31 and multiplied by the control signal Qi outputted from the counter 11. The control signal Qi outputted from the counter 11 to the multiplier 31 takes "0" during a time period of 42.5 µs [15 * 2.83 µs (= Ni/fₛ) ], i.e., during a "15" clock time period. As a result, an output of the multiplier 31 is zero during the "15" clock time period irrespective of the value of the data delayed by "23" clocks. By representing the input data by dₚ, an output of the accumulative adder 41 is ( dₚ₋₈ + dₚ₋₉ + ... + dₚ₋₂₂) at the time after 42.5 µs corresponding to "15" clocks.

The control signal Qi takes "- 1" after the time period of 42.5 µs, i.e., during the time period after "16" clocks. Representing the accumulative value of the accumulative adder 41 at the time after 42.5 µs corresponding to "15" clocks by Σ₀₁(= dₚ₋₈ + dₚ₋₉ + ... + dₚ₋ ₂₂), the first data and second data read in a time period of 2.83 µs next to the time period of 42.5 µs, i.e., during the "16"-th clock, are dₚ₋₇ and dₚ₋₂₂, respectively. The accumulative value Σ₀₀₁ of the accumulative adder 41 is Σ₀₁ + dₚ₋₇ - dₚ₋₂₂ at the time after 45.33 (16 * 2.83) µs, i.e., during the "16"-th clock. In this case, the accumulative adder 41 performs two additions of adding two sets of data (dₚ₋₇) and (- dₚ₋₂₂) read in the time period of 2.83 µs to the preceding accumulative value Σ₀₁.

By substituting the accumulative value Σ₀₁(= dₚ₋₈ + dₚ₋ ₉ + ... + dₚ₋₂₂), the accumulative value Σ₀₀₁ becomes (dₚ₋₇ + dₚ₋₈ + dₚ₋₉ + ... + dₚ₋₂₂ - dₚ₋₂₂) = (dₚ₋₇ + dₚ₋₈ + dₚ₋₉ + ... + dₚ₋₂₁). This means that the accumulative adder 41 accumulatively adds the first data and deletes the preceding most latest data. Thereafter, the similar operation is repeated at each time period of 2.83 µs. An output of the accumulative adder 41 is multiplied by 1/15 by the multiplier 51.

Similar to the above, in the second low-pass filter LPF2, at the same time when input data is written, the counter 11 outputs the reset signal to reset the accumulative adder 42. After this resetting and in parallel to writing input data into the memory 12, two sets of data delayed by "0" clock and by "31" clocks from the input data are read from the memory 12 in a time period of 2.83 µs (= 1/352.8 kHz). The data delayed by "0" clock is supplied to the accumulative adder 42 and accumulatively added.

The data delayed by "31" clocks is supplied to the multiplier 32 and multiplied by the control signal Qi outputted from the counter 11. The control signal Qi outputted from the counter 11 to the multiplier 32 takes "0" during a time period of 87.9 µs [31 * 2.83 µs (= Ni/fₛ)], i.e., during a "31" clock time pericd. As a result, an output of the multiplier 32 is zero during the "31" clock time period irrespective of the value of the data delayed by "31" clocks. By representing the input data by dₚ, an output of the accumulative adder 42 is (dₚ + dₚ₋₁ + ... + dₚ₋₃₀) at the time after 87.9 µs corresponding to "31" clocks.

The control signal Qi takes "- 1" after the time period of 87.9 µs, i.e., during the time period after "32" clocks. Representing the accumulative value of the accumulative adder 42 at the time after 87.9 µs corresponding to "32" clocks by Σ₀₂(= dₚ + dₚ₋₁ + ... + dₚ₋ ₃₀), the third data and fourth data read in a time period of 2.83 µs next to the time period of 87.9 µs, i.e., during the "32"-th clock are dₚ₊₁ and dₚ₋₃₀, respectively. The accumulative value Σ₀₀₂ of the accumulative adder 42 is Σ₀₂ + dₚ₊₁ - dₚ₋₃₀ at the time after 90.73 (32 * 2.83) µs, i.e., during the "32"-th clock. In this case, the accumulative adder 42 performs two additions of adding two sets of data (dₚ₊₁) and (- dₚ₋₃₀) read in the time period of 2.83 µs to the preceding accumulative value Σ₀₂.

By substituting the accumulative value Σ₀₂(= dₚ + dₚ₋₁ + ... + dₚ₋₃₀), the accumulative value Σ₀₀₂ becomes (dₚ₊₁ + dₚ + dₚ₋₁ + ... + dₚ₋₃₀ - dₚ₋₃₀) = (dₚ₊₁ + dₚ + dₚ₋₁ + ... + dₚ₋₂₉). This means that the accumulative adder 42 accumulatively adds the third data and deletes the preceding most latest data. Thereafter, the similar operation is repeated at each time period of 2.83 µs. An output of the accumulative adder 42 is multiplied by 1/31 by the multiplier 52.

In this embodiment, therefore, the accumulative adders 41 and 42 perform four additions in total during each time period of 2.83 µs.

The group delay time required for the calculation by the FIR filter corresponds to (Ni - 1)/2 clocks where Ni is the number of taps. Therefore, the group delay time required for the calculation by the low-pass filter LPF1 is a 7 clock time period, and that of the low-pass filter LPF2 is a 15 clock time period. However, since the data inputted to the low-pass filter LPF1 has been delayed by an 8 time clock time period, its group delay time is a 15 clock time period in total.

Similarly, since the data inputted to the low-pass filter LPF2 has been delayed by a 0 clock time period, its group delay time is a 15 clock time period. The group delay times of the low-pass filters LPF1 and LPF2 are therefore equal.

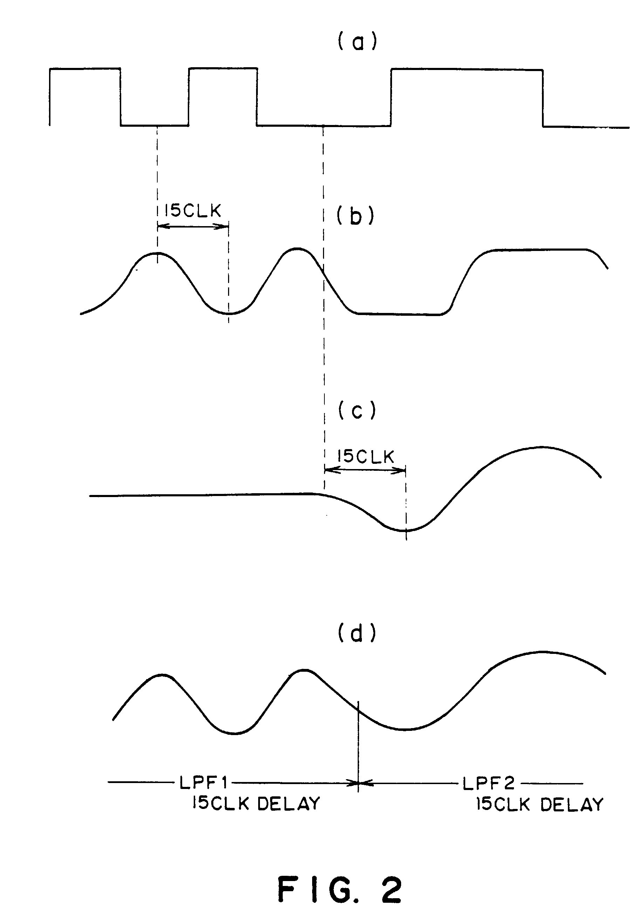

Input data is supplied to the correlation detector 17 to detect a correlation between data at one time point and nearby data. If input data has an envelope indicated at (a) in Fig.2, an envelope of output data from the low-pass filter LPF1 becomes as indicated at (b) in Fig.2, and an envelope of output data from the low-pass filter LPF2 becomes as indicated at (c) in Fig.2.

The first half of the input data indicated at (a) in Fig.2 has a low correlation so that the output data from the low-pass filter LPF1 is selected, whereas the second half of the input data has a high correlation so that the output data from the low-pass filter LPF2 is selected. Output data from the selector 16 therefore becomes as indicated at (d) in Fig.2. As described before, because both the group delay times of the low-pass filters LPF1 and LPF2 are the same 15 clock time period, no distortion is generated upon switching by the selector 16.

The meaning of m will be explained. The group delay time required for the calculation by a low-pass filter corresponds to (Ni - 1)/2 clocks, and changes with the number of taps of the low-pass filter. The first data delayed by [m - (Ni - 1)/2] clocks from input data and the second data delayed by [m + (Ni - 1)/2 + 1] clocks from the input data are read from the memory 12, where m ≥ (Ni - 1)/2.

At a certain time period after the counter 11 outputs the control signal Qi = "- 1" to the multipliers 31 and 32, the accumulative value at the time period immediately before the certain time period is a value obtained by adding data at the time period corresponding to [m - (Ni - 1)/2 + 1] clocks before + ... + data at the time period corresponding to [m + (Ni - 1)/2 + 1) clocks before. The accumulative value at the certain time period is a value obtained by adding data at the time period corresponding to [m - (Ni - 1)/2] clocks before to, and by subtracting data at the time period corresponding to [m + (Ni - 1)/2 + 1] clocks before from, the cumulative value at the time period immediately before the certain time period. Therefore, the accumulative value at the certain time period is a value obtained from data at the time period corresponding to [m - (Ni - 1)/2] clocks before + data at the time period corresponding to [m - (Ni - 1)/2 + 1] clocks before + ... + data at the time period corresponding to [m + (Ni - 1)/2] clocks before.

Even the newest data in the multipliers 41 and 42 is data at the time period corresponding to [m - (Ni - 1)/2] clocks before. In this case, the group delay time between input data to the memory 12 and output data from the multipliers 41 and 42 is obtained by adding the [m - (Ni - 1)/2 ] clock time to the group delay time required for the calculation by the low-pass filter, which is {[m - (Ni - 1)/2] + [Ni - 1)/2]} = m. The group delay time is therefore an m clock time.

The group delay time of the accumulative output from the multipliers 41 and 42 is therefore an m clock time which is independent from the number of taps so that the group delay time will not be changed by the operation of the selector 16.

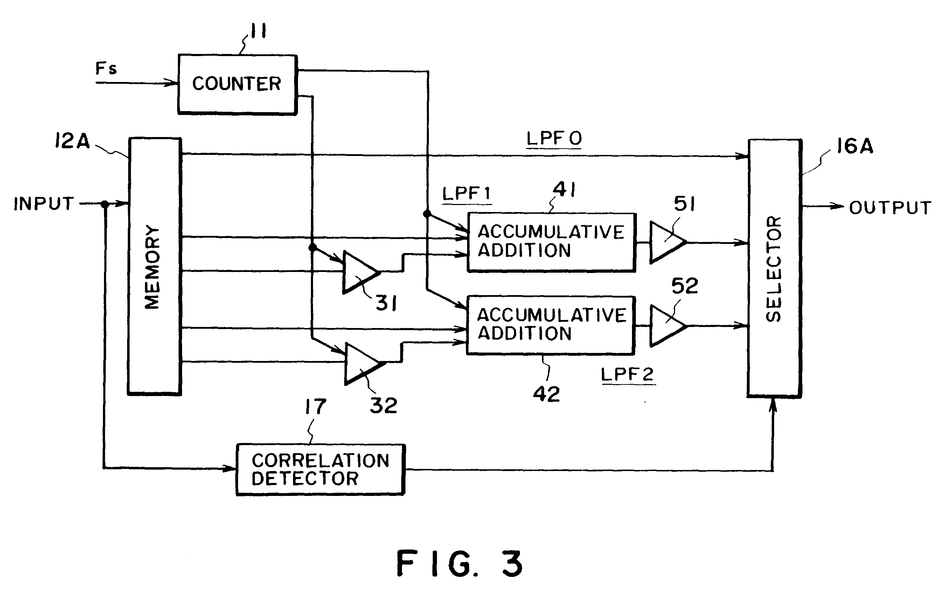

Next, a first modification of the embodiment will be described. Fig.3 is a block diagram showing the structure of the first modification. In the first modification, a low-pass filter having one tap is added to the embodiment. The low-pass filter LPF0 having one tap is a through filter without no cut-off frequency. In the first modification, data delayed by 15 (= m) clocks from input data is supplied from a memory 12A corresponding to the memory 12 shown in Fig.1 to the low-pass filter LPF0. Low-pass filters LPF1 and LPF2 are structured in the same manner as the embodiment shown in Figs.1 and 2. A selector 16A corresponding to the selector 16 shown in Fig.1 selects one of outputs from the low-pass filters LPF0, LPF1, and LPF2 in accordance with an output from a correlation detector 17.

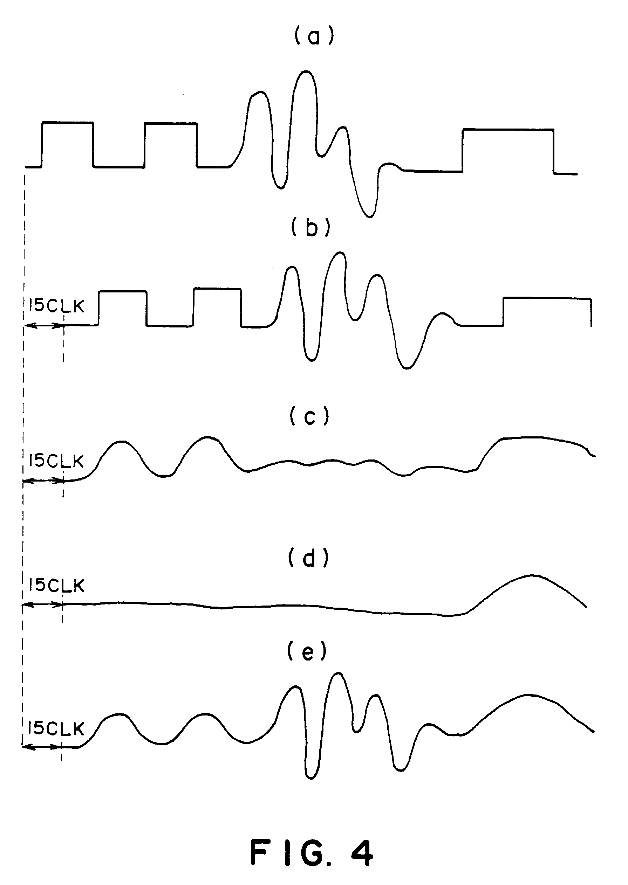

In the first modification, input data having an envelope such as indicated at (a) in Fig.4 is filtered by the low-pass filters LPF0, LPF1, and LPF2. Envelopes of outputs of the low-pass filters LPF0, LPF1, and LPF2 are shown as indicated at (b), (c), and (d). The group delay times for the low-pass filters LPF0, LPF1, and LPF2 are the same 15 clock time.

The correlation detector 17 detects a correlation between input data. In the case of the input data indicated at (a) in Fig.4, the start portion of the input data has some correlation so that the selector 16A selects an output from the low-pass filter LPF1 in accordance with an output from the correlation detector 17. The middle portion of the input data has no correlation so that an output of the low-pass filter LPF0 is selected. The end portion of the input data has a high correlation so that an output of the low-pass filter LPF2 is selected. An output from the selector 16A has an envelope such as indicated at (e) in Fig.4.

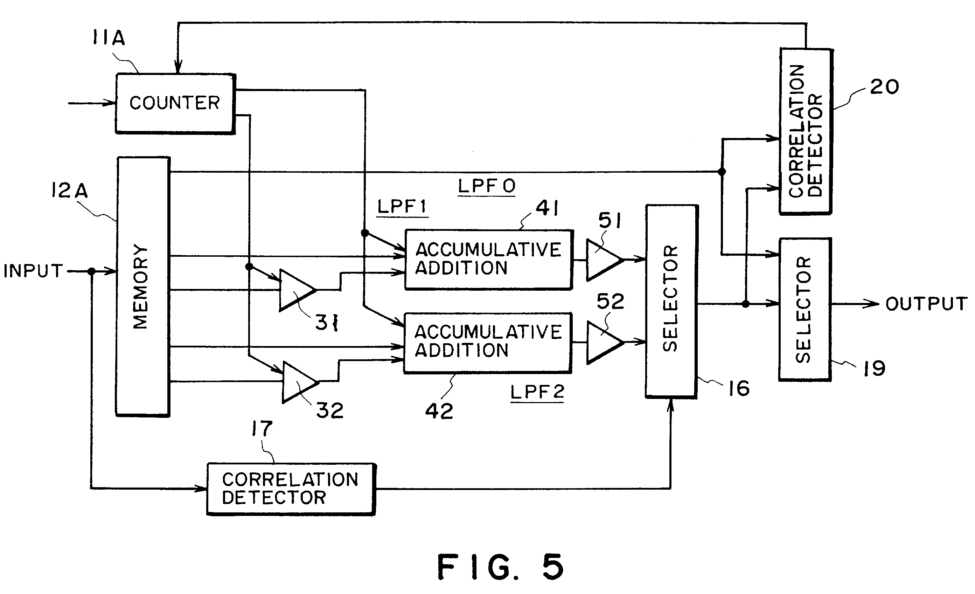

Next, a second modification of the embodiment will be described. Fig.5 is a block diagram showing the structure of the second modification. In the second modification, a counter 11A corresponding to the counter 11 shown in Fig.1 has an external reset function. A selector 16 selects one of outputs from low-pass filters LPF1 and LPF2 in accordance with an output from a correlation detector 17. An output from the selector 16 and an output of a low-pass filter LPF0 are supplied to another selector 19. A correlation between an output from the selector 16 and an output from the low-pass filter LPF0 is detected by another correlation detector 20.

When a correlation output from the correlation detector 20 becomes lower than a predetermined value, the counter 11A is reset so that the selector 19 selects an output from the low-pass filter LPF0 while the counter 11A supplies "0" to the multiplier 32, i.e., during a 31 clock time period. If a correlation output from the correlation detector 20 takes the predetermined value or higher, the selector 19 selects an output from the selector 16.

In the second modification constructed as above, the operation of the components other than the low-pass filter LPF0, selector 19, and correlation detector 20 is the same as the embodiment shown in Figs.1 and 2, and the description thereof is omitted. The group delay time of the low-pass filter LPF0 is a 15 clock time period, and the group delay time of an output from the selector 16 is the same 15 clock time period.

If noises enter the multipliers 41 and 42 because of external disturbances, malfunctions of the filter, or the like, a correlation output from the correlation detector 20 becomes lower than the predetermined value and the counter 11A is reset and outputs a reset signal to the multipliers 41 and 42 to reset them. Thereafter, the same operation described in the embodiment shown in Figs.1 and 2 is performed. In this manner, noises in the multipliers are cleared. When the counter 11A is reset, the selector 19 selects an output from the low-pass filter LPF0. The group delay time does not change at this selection so that no distortion is generated.

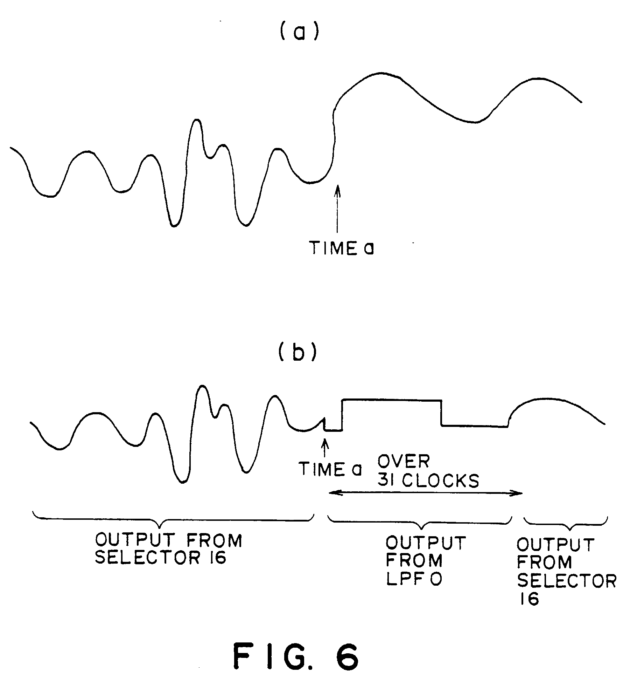

It is assumed that the same input data as the first modification and that an output from the selector 19 has an envelope indicated at (a) in Fig.6 and noises enter at time α indicated at (a) in Fig.6. In this case, as indicated at (b) in Fig. 6, an output before the time α is the same as the output indicated at (a) in Fig.6. During the 31 clock time period or longer after the time α, the selector 19 selects an output from the low-pass filter LPF0. When a correlation output from the correlation detector 20 takes the predetermined value or higher, the selector 19 selects an output from the selector 16.

As described so far, according to the digital filter of this invention, the number of additions to be executed by a multiplier of each low-pass filter is twice, and the number of additions to be executed by multipliers of all low-pass filters is the number of low-pass filters multiplied by 2 which is very small as compared to the conventional digital filter. Furthermore, the group delay time of each low-pass filter of the digital filter is the same so that distortions to be caused by the operation of the selector can be suppressed.

Still further, if a correlation between output data from the first selector and output data from each low-pass filter delayed by m clocks from input data is smaller than a predetermined value, the multiplier is reset. Therefore, if noises enter the multiplier, this is detected and the multiplier is reset, thereby suppressing the influence of entered noises.

## Claims

1. A digital filter comprising:
a first correlation detector (17) for detecting a correlation of input data sampled by a pulse having a frequency fₛ;
a plurality of digital low-pass filters (LPF1, LPF2) each having a different number Ni of taps for reading, from a memory (12, 12A), first data delayed by [m - (tap number Ni - 1)/2] clocks from said input data sequentially written in said memory (12, 12A) in response to a write clock synchronizing said frequency fₛ and second data delayed by [m + (tap number Ni - 1)/2 + 1] clocks from said input data, each said digital low-pass filter (LPF1, LPF2) including a first multiplier (31, 32) for multiplying said second data by a control signal, an accumulative adder (41, 42) being reset by a reset signal for accumulatively adding said first data and data output from said first multiplier (31, 32), and a second multiplier (51, 52) for multiplying output of said accumulative adder by 1/Ni, wherein m is a natural number of (Ni - 1)/2 or larger;
a first selector (16, 16A) for selecting one of the outputs of said plurality of digital low-pass filters (LPF1, LPF2) in accordance with a first correlation output between said input data detected by said first correlation detector; and
a counter (11, 11A) for outputting said reset signal when starting a count, counting said pulse, outputting said control signals individually for each of said low-pass filters (LPF1, LPF2), said control signals being 0 during a time period of Ni clocks and being -1 thereafter.

2. The digital filter according to claim 1, further comprising:
a second selector (19) for selecting either said output selected by said first selector (16, 16A) or third data delayed by m clocks from said input data and read from said memory (12, 12A); and
a second correlation detector (20) for detecting a correlation between said output data selected by said first selector (16) and said third data delayed by m clocks and for resetting said counter (11A) to restart counting and making said second selector (19) to select said third data if said correlation detected by said second correlation detector (20) does not reach a predetermined value.

## Patentansprüche

1. Digitalfilter mit:
einer ersten Korrelationserfassungseinrichtung (17) zum Erfassen einer Korrelation von mit einem Puls mit einer Frequenz fₛ abgetasteten Eingangsdaten;
einer Mehrzahl von Digitaltiefpaßfiltern (LPF1, LPF2) mit jeweils einer unterschiedlichen Zahl Ni von Abgriffen zum aus einem Speicher (12, 12A) Auslesen von um [m - (Abgriffszahl Ni - 1)/2] Takten gegenüber sequentiell in den Speicher (12, 12A) entsprechend einem die Frequenz fₛ synchronisierenden Einschreibtakt sequentiell eingeschriebenen Eingangsdaten verzögerten ersten Daten und um [m + (Abgriffszahl Ni - 1)/2 + 1] Takten gegenüber den Eingangsdaten verzögerten zweiten Daten, wobei jedes der Digitaltiefpaßfilter (LPF1, LPF2) aufweist einen ersten Multiplizierer (31, 32) zum Multiplizieren der zweiten Daten mit einem Steuersignal, einen akkumulierenden Addierer (41, 42), der durch ein Rücksetzsignal rückgesetzt wird zum akkumulierenden Addieren der ersten Daten und aus dem ersten Multiplizierer (31, 32) ausgegebener Daten, und einen zweiten Multiplizierer (51, 52) zum Multiplizieren eines Ausgangssignals des akkumulierenden Addierers mit 1/Ni, wobei m eine natürliche Zahl und mindestens (Ni - 1)/2 ist;
einer ersten Auswahleinrichtung (16, 16A) zum Auswählen eines der Ausgangssignale der Mehrzahl Digitaltiefpaßfilter (LPF1, LPF2) entsprechend einem ersten Zwischenden-Eingangsdaten-Korrelationsausgangsignal, erfaßt durch die erste Korrelationserfassungseinrichtung; und
einem Zähler (11, 11A) zum beim Starten einer Zählung Ausgeben des Rücksetzsignals, Zählen des Pulses, Ausgeben des Steuersignals individuell für jedes der Tiefpaßfilter (LPF2, LPF2), wobei die Steuersignale während einer Zeitspanne von Ni-Takten 0 und danach -1 sind.

2. Digitalfilter nach Anspruch 1 ferner mit:
einer zweiten Auswahleinrichtung (19) zum Auswählen entweder des von der ersten Auswahleinrichtung (16, 16A) ausgewählten Ausgangssignals oder um m-Takte gegenüber den Eingangsdaten verzögerter und aus dem Speicher (12, 12A) ausgelesener dritten Daten; und
einer zweiten Korrelationserfassungseinrichtung (20) zum Erfassen einer Korrelation zwischen den von der ersten Auswahleinrichtung (16) ausgewählten Ausgangsdaten und den um m-Takte verzögerten dritten Daten und zum Rücksetzen des Zählers (11A) zum Wieder-Starten des Zählens und zum die zweite Auswahleinrichtung (19) zum Auswählen der dritten Daten, wenn die durch die zweite Korrelationserfassungseinrichtung (20) erfaßte Korrelation einen vorbestimmten Wert nicht erreicht, Bringen.

## Revendications

1. Filtre numérique comprenant :
un premier détecteur de corrélation (17) pour détecter une corrélation de données d'entrée échantillonnées par une impulsion ayant une fréquence fₛ ;
un certain nombre de filtres passe-bas numériques (LPF1, LPF2) ayant chacun un nombre différent Ni de bornes pour lire, à partir d'une mémoire (12, 12A), des premières données retardées de [m - nombre de bornes Ni - 1)/2] signaux d'horloge à partir desdites données d'entrée séquentiellement écrites dans ladite mémoire (12, 12A) en réponse à un signal d'horloge d'écriture synchronisant ladite fréquence fₛ et des secondes données retardées de [m + (nombre de bornes Ni - 1)/2 + 1] signaux d'horloge desdites données d'entrée, chaque filtre passe-bas numérique (LPF1, LPF2) comprenant un premier multiplicateur (31, 32) pour multiplier lesdites secondes données par un signal de commande, un additionneur accumulatif étant réinitialisé par un signal de réinitialisation pour additionner accumulativement lesdites premières données et les données produites par ledit premier multiplicateur (31, 32), et un second multiplicateur (51, 52) pour multiplier une sortie dudit additionneur accumulatif par 1/Ni, où m est un nombre naturel de (Ni - 1)/2 ou plus grand ;
un premier sélecteur (16, 16A) pour sélectionner l'une des sorties de ladite pluralité de filtres passe-bas numériques (LPF1, LPF2) selon une première sortie de corrélation entre lesdites données d'entrée détectées par ledit premier détecteur de corrélation ; et
un compteur (11, 11A) pour produire ledit signal de réinitialisation lorsque démarre un comptage, compter ladite impulsion, produire lesdits signaux de commande individuellement pour chacun desdits filtres passe-bas (LPF1, LPF2), lesdits signaux de commande étant 0 pendant une période de temps de Ni signaux d'horloge et étant -1 ensuite.

2. Filtre numérique selon la revendication 1, comprenant de plus :
un second sélecteur (19) pour sélectionner soit la sortie précitée choisie par le premier sélecteur précité (16, 16A), soit des troisièmes données retardées de m signaux d'horloge à partir des données d'entrée précitées et lues de la mémoire précitée (12, 12A) ; et
un second détecteur de corrélation (20) pour détecter une corrélation entre les données de sortie précitées sélectionnées par le premier sélecteur et lesdites troisièmes données retardées de m signaux d'horloge et pour réinitialiser le compteur précité (11A) pour redémarrer le comptage et amener ledit second sélecteur (19) à sélectionner lesdites troisièmes données si ladite corrélation détectée par ledit second détecteur de corrélation (20) n'atteint pas une valeur prédéterminée.
